Europäisches Patentamt

European Patent Office

Office européen des brevets

(11) Publication number: **0 580 224 A2**

## EUROPEAN PATENT APPLICATION

(21) Application number: 93202067.0

(51) Int. Cl.5: **H04N 5/21**

(22) Date of filing: 16.07.93

(30) Priority: **22.07.92 IT TO920624**

(43) Date of publication of application:
**26.01.94 Bulletin 94/04**

(84) Designated Contracting States:
**DE ES FR GB IT NL PT**

(71) Applicant: **SELECO S.p.A.**
**Viale Treviso, 15**
**I-33170 Pordenone(IT)**

(72) Inventor: **Dassie', Lucio**
**via Casano 80**
**I-32014 Ponte delle Alpi (BL)(IT)**

(74) Representative: **Dini, Roberto, Dr. Ing.**
**Via Castagnole, 59**
**I-10060 None (Torino) (IT)**

(54) Anti-reflection circuit for video and teletext signals with subdivision of the global filter in a plurality of filters with a reduced number of coefficients.

(57) The present invention relates to an anti-reflection circuit for video and/or teletext signals, comprising one or more numeric filters and a processor; the main characteristic of the invention consists in the fact that the circuit comprises a filtering section, composed of at least one numeric filter, and an elaboration section, entrusted to said processor, and that the elaboration section provides for reducing the number of coefficients from a number M to a number N lower than M, carrying out an elaboration, so as that the filtering section, in its assembly, implements an adaptive filter of a wide support but being of a reduced number of coefficients.

The present invention relates to an anti-reflection circuit for video and/or teletext signals, comprising one or more adaptive numeric filters and a processor.

It is known that the effect of reflections (ghost) that become part of the video signal is extremely deleterious due to the visual effects that it causes (compare for example J. M. Corbett and J. W. Allnatt "Subjective quality of television impaired by short delay echo", IEEE Proc. Vol. 121, No. 7, July 1974; and A. M. Lessman, "The color television and the resulting echo time weighting", journal of SMPTE, vol. 81, December 1972).

Such effects are manifested be it either as a simple amplitude variation, of different polarity and duration, or as a more complex mixing of video signals; regarding this the degradation of the colour PAL in certain situations of reflections results in being particularly damaging.

The most insidious source of echoes for signals irradiated on terrestrial television station links is the well known multipath propagation caused by the reflection of the signals on natural or artificial obstacles (mountains, tall buildings etc.); in certain cases there are even temporary effects, such as those produces by vehicles (airplane flutter), particularly felt in the vicinity of airports.

Another source of reflections derives from inappropriate antennas that, in theory can be remedied with accurate systems, though in practice it is not so.

The problem has gradually become worse due to the ever increasing number of television broadcasters, the increase in the number of buildings, the not always correct installation of antennas, and other causes, moreover with high definition transmissions not so far away enlarges the problem in that the reflection effect is more felt in a signal having a duration of minor lines.

The digital elaboration of signals seems to be a good instrument for minimising the defects deriving from spurious reflections; systems have in fact been proposed for cancelling or weakening the reflections in a video signal; see for example:

(1-) W. Cicoria et al., "A tutorial on ghost cancelling in television systems", IEEE Trans. on C.E., vol. 25, Feb. 1979;

(2-) M. G. Larimore et al., "SHARF: an algorithm for adapting IIR digital filters", IEE Trans. on ASSP, vol. 28, Aug. 1980__;

(3-) T. H. S. Chao, "Multi-path equalization for NTSC video by using digital I.I.R. filter", IEEE Trans. on C.E., vol. 34, Feb. 1988;

(4-) M. Pazarci, "An adaptive ghost processor for broadcast television", IEEE Trans. on C.E., vol. 35, Aug. 1989.

In (1) a panorama is made of the possibilities with the use of traversal filters; in (3) and (4) algorithms can be traced making use of filters being purely of the I.I.R. type (Infinite Impulse Response), that in the limits of the evaluated solutions, require an elevated number of coefficients and are subject to instability; the proposed algorithm in (4) maintains the characteristics of stability (see 2) at the cost of laborious and not easily identified calculations; in both the mentioned articles the initial conditions of the inappropriate signal do not consider the inappropriate compound deriving from the uncertainty on the carrier extracted from the intermediate frequency signal.

It results that the known systems, for equalising delays in the range of tens of microseconds and more, require filters of an extremely high number of coefficients, have dangers of instability, do not realise a high quality of compensation; moreover they are not very versatile; i.e. are not adapt for all practical cases, that can be simplifies as follows:

a) demodulated signal from a radio frequency to a domestic television; in such case it is not however possible to recover the component in quadrature;

b) demodulated signal from a radio frequency on a professional apparatus, on which said recovery is possible;

c) signals in a television studio, in particular high definition signals.

In the Italian patent application N. 67503-A/90 a compensation system of reflections in video signals was proposed, that provides for a first functional mode in which it operates on a very high number of coefficients of the filter, and a second functional mode in which it operates on a greatly reduced number of said coefficients, appropriately selected.

However in the case of considerable delays, in the range of tens of microseconds, in practice a number of coefficients of the filters in the range hundreds would be necessary, to the accustomed reference frequency of 13,5 MHz; therefore filters being very complex and encumbersome.

The aim of the present invention is that of illustrating an improved method that permits, in the indicated cases, to reduce the overall size of the filters to a more satisfactory level.

So as to obtain the indicated aim, the present invention has as it subject an anti-reflection circuit for video and/or teletext signals, comprising one or more numeric filters and a processor, characterised in that the circuit comprises a filtering section, composed of at least one numeric filter, and an elaboration section, entrusted to said processor, and that the elaboration section provides for reducing the number of coefficients from a number M to a number N lower than M, carrying out an elaboration, so as that the filtering section, in its assembly, implements an adaptive filter of a wide support but being of a reduced number of coefficients.

Further aims and advantages of the present invention shall result in being clear from the following detailed description and annexed drawings, supplied purely as an explicative and non limiting example, wherein:

- figure 1 represents in a schematic manner the functional principles of a circuit for filtering the disturbances caused by reflections;
- figure 2 represents in a schematic manner the method followed for reducing the number of coefficients according to the invention;
- figure 3 exemplifies by way of a series of diagrams the method for selecting coefficients according to the invention. The method for realising the circuit in question is predisposed not only for the equalisation of the video signal, but also for reducing the rate of errors in the transmission of data (teletext, HDTV).

The method is adaptive, in the sense that monitoring the video signal, it permits to continuously update the coefficients of the filters that equalise it from echoes.

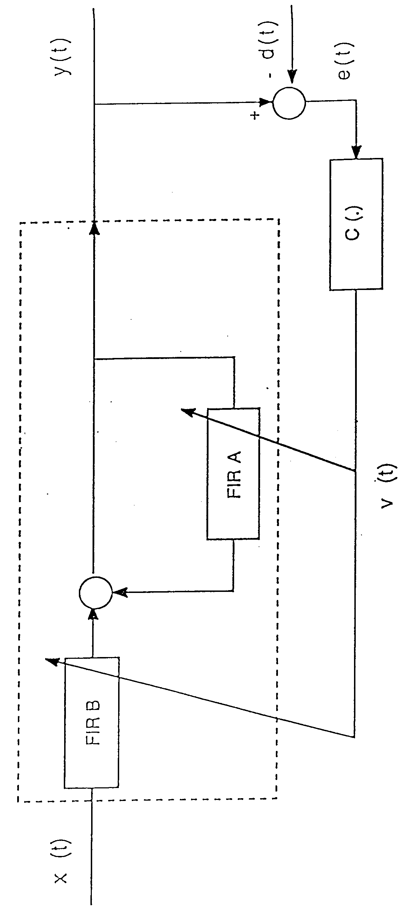

In reference to figure 1, the part within the dotted line identifies the filtering section, while the part outside the dotted line is relative to the adaptive algorithm, that implements in a processor.

From the video signal an appropriate line is extracted, said ITS (Insertion Test Signal) that, compared with its ideal version, gives an error the entity of which is a function of the echoes present in the signal. This error is utilised by the processor for calculating the coefficients of the filters that will equalise the signal; more precisely the equations for the calculation of the coefficients are:

$$a_i(k) = a_i(k-1) + uy(k-i-1)v(k-1) \text{ i comprised between 1 and L}$$
$$b_i(k) = b_i(k-1) + rx(k-i-1)v(k-1) \text{ i comprised between 1 and P}$$
$$e(k) = y(k)-d(k)$$
$$v(k) = c(k) + \text{ summation for 1 from 1 to q of } C_1(k-1)$$

where $a_i(k)$ and $b_i(k)$ are respectively the L and P coefficients of the FIRA and of the FIRB to the time k; u and r are constants; e(k) is the error function; v(k) is a version of the error filtered by the filter c(.) of support q.

The reduction of the number of the coefficients (taps clustering) is entrusted to an algorithm carried out by a processor that subdivides the filter to $M = L + P$ coefficients in K filters to N coefficients; carries out for each of these an adaptive process so as to obtain a partial equalisation error Ek based on which, finally, the N coefficients (according to the criterion of maximum amplitude) are selected.

With a more detailed look at the invention, the global theoretic filter of extended support ($M = KN$ coefficients) is divided in K partial filters of N coefficients, such though that the union of their single supports gives however the support of the global filter.

The adaptive process is carried out for every single partial filter so as to obtain an equalisation error Ek corresponding to the coefficients Ckj (J greater than or equal to 1; J lower than or equal to N) of the K order filter; the union of the coefficients Ckj of the K filters provides an assembly of M coefficients; after having weighted the latter for the contrary of their error Ek, they choose the N of a greater module; starting from these a further adaptive process is carried out for adjusting in a fine way the system towards a more correct equalisation.

Upon termination of the latter, the coefficients thus obtained are then effectively charged in the implemented filters; in this way a modest echo equalisation of considerable delay is obtained even though only N of the M coefficients is utilised.

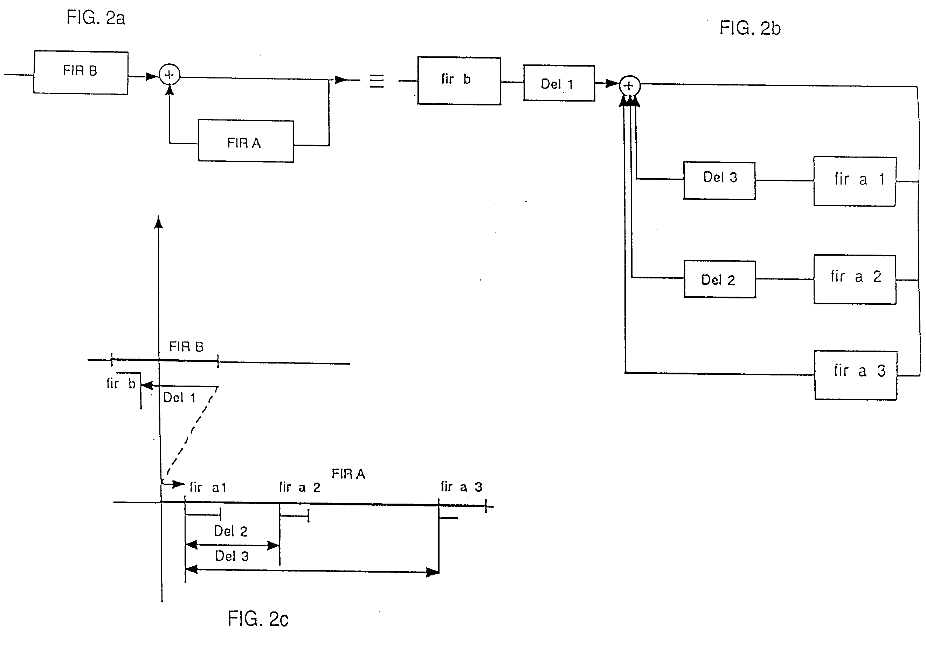

In figure 2a the equaliser circuit is represented, if a reduction of the coefficients is not carried out, in which FIR A and FIR B are filters of the Finite Impulse Response type and have support as indicated in figure 2c.

In figure 2b the equaliser circuit with reduction of the coefficients is represented, the filters of which have support deducible from figure 2c, Del1, Del2 and Del3 are delay circuits that have the purpose of appropriately relationing the partial filterings of the single branches.

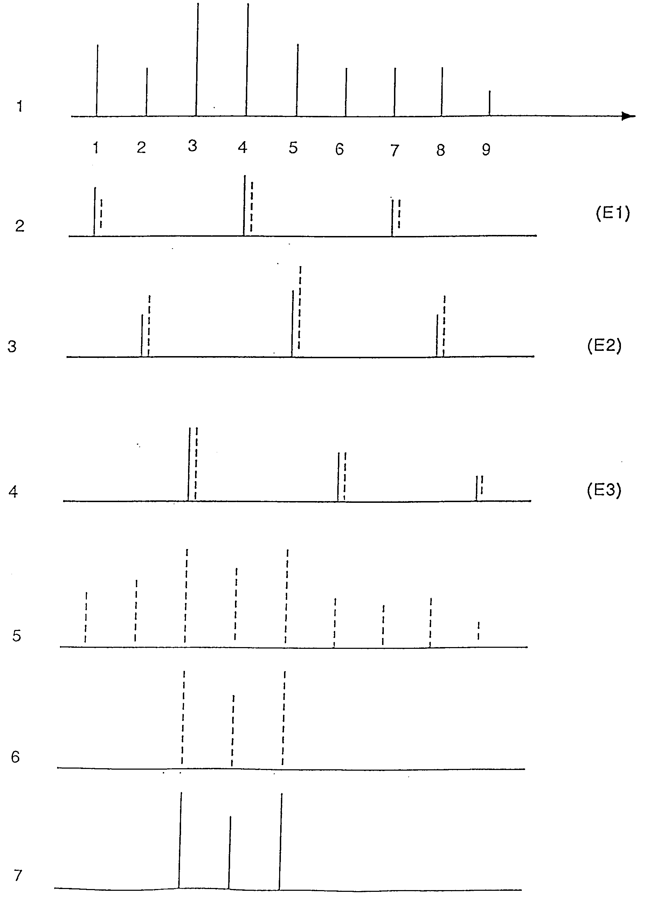

Figure 3 exemplifies the selection method of the coefficients according to the invention.

In the first line the reply of a filter of 9 coefficients to be reduced to 3 is represented.

In the second, third and fourth lines with continuous lines the coefficients of the first, second and third partial filter of 3 coefficients are respectively represented, and with the dotted line the running of the same after the partial adaptive process that gives errors respectively E1, E2 E3.

In line 5 the coefficients of the previous filters are united, once they have been weighted for the contrary of their respective errors E1, E2, E3.

In line 6 the 3 coefficients of a greater module are selected and finally in line 7 the 3 coefficients obtained after a further equalisation are indicated; the latter are effectively charged in the filters that equalise the signal.

The characteristics of the filter subject of the present invention result in being clear from the description of the example.

From the present invention the advantages of the filter subject of the present invention also result in being clear.

In particular they consist in the fact that a filter is obtained with a number of coefficients being greatly reduced compared to the initial one, still preserving a reasonable equalisation capacity.

It is clear that numerous variants are possible by the skilled man, to the filter described as an example, without for this departing from the novelty principles inherent in the invention.

**Claims**

1. Anti-reflection circuit for video and/or teletext signals, comprising one or more numeric filters and a processor, characterised in that the circuit comprises a filtering section, composed of at least one numeric filter, and an elaboration section, entrusted to said processor, and that the elaboration section provides for reducing the number of coefficients from a number M to a number N lower than M, carrying out an elaboration, so as that the filtering section, in its assembly, implements an adaptive filter of a wide support (M) but being of a reduced number (N) of coefficients.

2. Anti-reflection circuit for video and/or teletext signals, according to claim 1, characterised by the fact that said processor, in its elaboration, subdivides the filter extended to M coefficients in K filters each having a number $N = M/K$ of coefficients, and that for each of the K filters an intermediate adaptive process is carried out so as to obtain a partial equalisation error Ek and that, based on such error, N coefficients are selected from those (M) obtained, according to the criterion of maximum amplitude, and that they are discharged from the processor at the filtering section.

3. Anti-reflection circuit for video and/or teletext signals, according to claim 2, characterised by the fact that said adaptive process is carried out for each single partial filter so as to obtain an equalisation error Ek corresponding to coefficients Ckj of the K order filter, that the union of the coefficients Ckj of the K filters gives an assembly of M coefficients; after having weighted the latter for the contrary of their error Ek, the N of a greater module are selected and that starting from these a further adaptive process is carried out for adjusting in a fine way the system towards a more correct equalisation.

4. Anti-reflection circuit for video and/or teletext signals, as resulting from the present description and annexed drawings.

EP 0 580 224 A2

FIG. 2a

FIG. 2b

```
──┤ FIR B ├──▶(+)──▶  ≡  ──┤ fir b ├──┤ Del 1 ├──▶(+)──────────────────────┐
                │                                    ▲▲▲                     │
                │                                    │││                     │
         ┌──────┴──────┐                      ┌──────┘││        ┌────────┐   │
         │    FIR A     │                     │  ┌────┤│  ┌─────┤ fir a 1├───┤
         └─────────────┘                      │  │Del 3│  └─────┘        └   │
                                              │  └─────┘                     │
                                              │                              │
                                              │  ┌─────┐        ┌────────┐   │
                                              │  │Del 2├──┤fir a 2├──────────┤
                                              │  └─────┘        └────────┘   │
                                              │                              │
                                              │            ┌────────┐        │
                                              └────────────┤ fir a 3├────────┘
                                                           └────────┘
```

FIG. 2c

FIG. 2c

EP 0 580 224 A2

7